# EUROPEAN PATENT SPECIFICATION

(11) **EP 2 337 170 B1**
(45) Date of publication and mention of the grant of the patent: **20.09.2017**
(21) Application number: 09179266.3
(22) Date of filing: 15.12.2009
(51) Int. Cl.: H01S 5/40, H01S 5/12, H01S 5/06

(54) **Method for manufacturing a tunable laser device and corresponding laser device**
Verfahren zur Herstellung einer abstimmbaren Laservorrichtung und zugehörige Laservorrichtung
Procédé de fabrication d'un dispositif de laser accordable et dispositif laser correspondant

(43) Date of publication of application: 22.06.2011
(73) Proprietor: ALCATEL LUCENT, 92100 Boulogne-Billancourt (FR)
(72) Inventor: Jentsch, Lothar, 15370 Fredersdorf (DE)
(74) Representative: Menzietti, Domenico

(56) References cited:
- US-A- 3 906 393
- SUDOH T K ET AL: "WAVELENGTH TRIMMING BY EXTERNAL LIGHT IRRADIATION - POST- FABRICATION LASING WAVELENGTH ADJUSTMENT FOR MULTIPLE-WAVELENGTH DISTRIBUTED-FEEDBACK LASER ARRAYS" IEEE JOURNAL OF SELECTED TOPICS IN QUANTUM ELECTRONICS, IEEE SERVICE CENTER, PISCATAWAY, NJ, US LNKD- DOI:10.1109/2944.605709, vol. 3, no. 2, 1 April 1997 (1997-04-01), pages 577-583, XP000735958 ISSN: 1077-260X
- OKI Y ET AL: "Long lifetime and high repetition rate operation from distributed feedback plastic waveguided dye lasers" OPTICS COMMUNICATIONS, NORTH-HOLLAND PUBLISHING CO. AMSTERDAM, NL LNKD- DOI:10.1016/S0030-4018(02)02125-9, vol. 214, no. 1-6, 15 December 2002 (2002-12-15), pages 277-283, XP004396710 ISSN: 0030-4018
- FORTE DI M A ET AL: "TUNABLE OPTICALLY PUMPED GAAS-GAALAS DISTRIBUTED-FEEDBACK LASERS" IEEE JOURNAL OF QUANTUM ELECTRONICS, IEEE SERVICE CENTER, PISCATAWAY, NJ, USA LNKD- DOI:10.1109/JQE.1978.1069858, vol. QE-14, no. 8, 1 August 1978 (1978-08-01), pages 560-562, XP009034390 ISSN: 0018-9197
- PEZESHKI B ET AL: "20-mW widely tunable laser module using DFB array and MEMS selection", IEEE PHOTONICS TECHNOLOGY LETTERS, IEEE SERVICE CENTER, PISCATAWAY, NJ, US, vol. 14, no. 10, 1 October 2002 (2002-10-01), pages 1457-1459, XP011426894, ISSN: 1041-1135, DOI: 10.1109/LPT.2002.802392

## Description

The invention relates to a manufacturing method according to the preamble of claim 1 and a laser device according to the preamble of claim 9.

A tunable laser device comprising the lasing member manufactured on a substrate by a lithographic manufacturing method and a light source being a UV-light source for illuminating said lasing member is known. Such tunable laser device is for example as laser device tunable by a change of temperature. Other kind of tunable laser devices are known for example from a PON system (PON: Passive Optical Network). During the manufacturing process of tunable laser devices, the slope of the wavelength versus ultraviolet LED current characteristic is not comparable to other similarly manufactured laser devices. That means wavelength measurement equipment is necessary during the installation process in a PON system.

The article "T. K. Sudoh et al."Wavelength Trimming by External Light Irradiation - Post Fabrication Lasing Wavelength Adjustment for Multiple Wavelength Distributed-Feedback Laser Array"; Quantum electronics, 3 (1997)2, pp. 577 - 583" shows a post fabrication lasting wavelength adjustment of a tunable DFB laser comprising a lasing member with a wavelength-selective structure, other lasing members with another wavelength-selective structures, and a laser light source for illuminating said lasing members.

Document US 3,906,393 describes an acoustically controlled distribution Feedback leaser comprising a lasing member with a wavelength-selective structure and a laser light source for illuminating said lasing member.

It is an object of the invention to provide a method for manufacturing and calibrating a tunable laser device comprising a lasing member with a wavelength-selective structure showing a well-known emission characteristic and to provide a corresponding tunable laser device.

This object is achieved by the present invention as defiled in claims 1 and 9. According to the invention the method for manufacturing and calibrating a tunable laser device, comprising a first lasing member with a first wavelength-selective structure, a second lasing member with a second wavelength-selective structure, and a light source for illuminating said lasing members, comprises the steps of:
(a) manufacturing an arrangement of the first lasing member and the second lasing member on a common substrate by means of a common lithographic manufacturing process, wherein the second lasing member is identical to the first lasing member, wherein the lasing members of the arrangement are illuminatable by the light source with the same intensity of light, wherein the chemical and/or mechanical structure of the lasing member may be changed because of the photo energy of the light emitted by the light source, wherein the light source is a UV-light source for emitting ultraviolet light, wherein the UV-light source is a UV-LED, and wherein the first lasing member, the second lasing member and the light source are encapsulated by a housing;
(b) generating calibration data of the tunable laser device by illuminating the second lasing member with light emitted by the light source, wherein the calibration data are based on a wavelength versus light source power characteristic, and tuning the corresponding laser beam by the use of the second wavelength-selective structure of said second lasing member; and
(c) storing said calibration data for adjusting the tunable laser device using the first lasing member.

Step (a) of manufacturing (establishing) the laser member together with the other lasing member preferably comprises growing of thin film structures and/or removing parts of said thin film structures or the bulk of the substrate. The growing e.g. is a growing by chemical vapour deposition (CVD) and/or physical vapour deposition (PVD). The removing is an etching, etc.

The stored calibration data, e.g. of this look up table, can be used in yet another step (d) for adjusting the tunable laser device using the one lasing member. The substrate preferably is a mono-crystalline substrate. The light source of the laser device especially is a light emitting diode (LED).

According to a preferred embodiment of the invention, the first lasing member and the second lasing member are at least substantially identical DFB-lasing members (DFB: distributed feedback) of the laser device. Therefore the corresponding laser device is a DFB-laser device.

A DFB-lasing member is the active region of a type of laser device, especially a laser diode. The DFB-laser member is periodically structured as a diffraction grating. The structure builds a one dimensional interference grating (enabling Bragg scattering), wherein the interference grating provides optical feedback for the laser device.

According to the invention, the light source is a UV-light source for emitting ultraviolet light. Because of the relatively high photo energy of the ultraviolet light emitted by the UV-light source, the chemical and/or mechanical structure of the second lasing member may change during the calibration process. The UV-light source especially is a UV-LED (light emitting diode emitting ultraviolet light).
According to yet another preferred embodiment of the invention, at least one lithographic tool for defining an identical lateral structure of the first lasing member and the second lasing member is used in the common manufacturing process. Preferably, said lithographic tool is a lithographic mask for defining the lateral structures of the first lasing member and the second lasing member.
This lithographic mask is e.g. a photo mask used in optical lithography. Optical lithography is a process used in micro-fabrication to selectively remove parts of a thin film or the bulk of a substrate. It uses light to transfer a geometric pattern from the photo mask to a light-sensitive chemical photo resist, or simply "resist," on the substrate. A series of chemical treatments then engraves the exposure pattern into the material underneath the photo resist. In complex integrated circuits, for example a modern CMOS, a wafer (die) will go through the photolithographic cycle up to 50 times.
In accordance with a preferred embodiment of the invention, the light source is manufactured on the substrate as well. Preferably said light source covers at least parts of the first lasing member and the second lasing member.

The substrate preferably at least is part of a semiconductor die or a chip.
In accordance with another preferred embodiment of the invention, the method further comprises the step of manufacturing a data storage structure on the chip for saving the calibrating data of the tunable laser device. In step (c) the generated calibration data are stored, e.g. as a look up table (LUT), in the data storage structure. The stored calibration data, e.g. of this look up table, can be used in a step (d) for adjusting the tunable laser device using the first lasing member.

In accordance with another preferred embodiment of the invention, the first lasing member is covered by an optical opaque cover member, especially a photo resist, during the step of generating the calibration data, wherein the optical opaque member is removed after executing this step of generating the calibration data. In other words: the first lasing member is shadowed during the generation of calibration data (the "calibration process") by a shielding, wherein this shielding is removed after the calibration process or step.

The invention further relates to a tunable laser device comprising a first lasing member with a first wavelength-selective structure, a second lasing member with a second wavelength-selective structure and a light source for illuminating said lasing members,
an arrangement of the first lasing member and the second lasing member being manufactured on a common substrate by means of a common lithographic manufacturing process,
wherein the first wavelength-selective structure of the first lasing member is identical to the second wavelength-selective structure of the second lasing member,
wherein the lasing members of the arrangement are illuminatable by the light source with the same intensity of light,
wherein the chemical and/or mechanical structure of the lasing member may be changed because of the photo energy of the light emitted by the light source,
wherein the light source is a UV-light source for emitting ultraviolet light, wherein the UV-light source is a UV-LED,
wherein the first lasing member, the second lasing member and the light source are encapsulated by a housing, and
wherein the laser device further comprises a data storage structure on the common substrate for saving calibrating data of the tunable laser device. Preferably the first lasing member and the second lasing member are at least substantially identical DFB-lasing members of the laser device. The light source especially is a UV-light source for emitting ultraviolet light. Because of the relatively high photo energy of the ultraviolet light emitted by the UV-light source, the chemical and/or mechanical structure of the lasing member may change during the calibration process. The UV-light source especially is a UV-LED (light emitting diode emitting ultraviolet light).
According to a preferred embodiment of the invention, the light source is arranged on the substrate as well.

According to the invention, the substrate is at least part of a semiconductor die or a chip. According to the invention, the laser device comprises a data storage structure on the chip for saving the calibrating data of the laser device.

According to the invention, the laser device comprises a housing for encapsulating the lasing member, the at least one other lasing member and the light source. At least one wall of the housing shows an opening for connecting a light guide element, e.g. a light guide fibre.
These and other aspects of the invention will be apparent from and elucidated with reference to the embodiments described hereinafter.
In the drawings:
Fig. 1 depicts a sectional view of a tunable laser device according to a first embodiment of the invention; and
Fig. 2 depicts a sectional view of a tunable laser device according to a second embodiment of the invention.

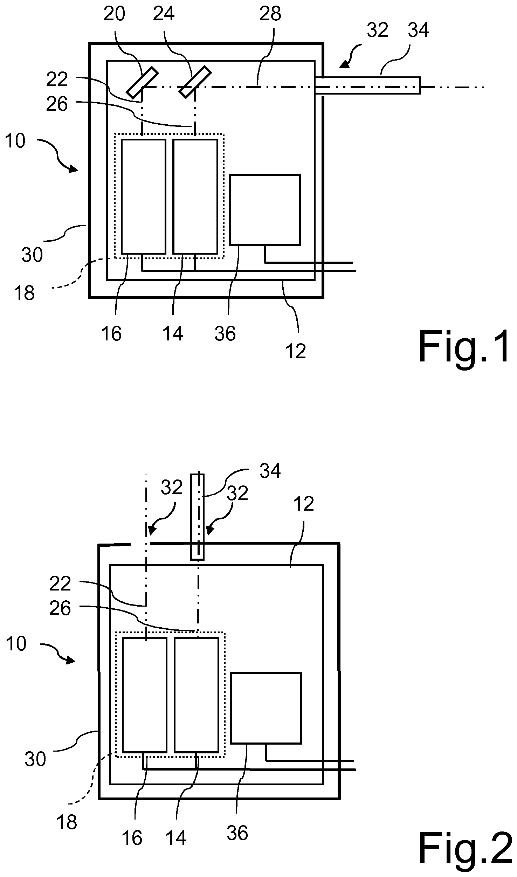

Fig. 1 shows a tunable laser device 10 comprising a chip (or a die) with a substrate 12 for two substantially identical laser members 14, 16, a lasing member 14 and another lasing member 16. Each of the lasing members 14, 16 comprises a wavelength-selective structure (not shown). The laser device 10 further comprises a light source (not shown) for illuminating the lasing members 14, 16. The light source and the lasing members 14, 16 are arranged in such a matter, that both members 14, 16 are illuminated/illuminatable by the light source with the substantially same light intensity. The corresponding arrangement 18 of the lasing member 14 and the other lasing member 16 is manufactured by means of a common lithographic manufacturing process. Each of these lasing members 14, 16 comprises a wavelength-selective structure and active lasing material.

The light source is (with respect to the sectional views of Figs. 1 and 2) arranged above or on-top of the lasing members 14, 16. The lasing members 14, 16 and the light source are arranged in a configuration, where the light source can illuminate each of the lasing members 14, 16 with the substantially same intensity of radiation without change in the fixed arrangement of these three elements: the lasing member 14, the other lasing member 16 and light source. The light source preferably is a light emitting diode (LED) emitting ultraviolet light (UV light).

The two lasing members 14, 16 are aligned in parallel to each other, wherein a first optical element 20 is located in the optical path 22 of the laser beam of the (one) lasing member 14 and a second optical element 24 is located in the optical path 26 of the laser beam of the other lasing member 16. Both optical elements 20, 24 are reflective elements. The optical elements 20, 24 unite the optical paths 22, 26 of the corresponding lasing members 14, 16 to a resulting common optical path 28 of both laser beams.

The lasing member 14, the other lasing member 16 and light source are encapsulated by a housing 30. The housing 30 comprises at least one opening 32 for plugging in an ending of a light guide member 34. The laser beam(s) of the common optical path 28 is/are coupled into this light guide member 34.

Fig. 2 shows a second embodiment of the laser device 10 with separate openings 32 for the laser beams of the lasing member 14 and the other lasing member 16. The laser beam generated by the lasing member 14 is coupled into the light guide member 34.

To ensure the structural identity of the two substantially identical laser members 14, 16, these laser members 14, 16 are manufactured by means of a common lithographic manufacturing process. The two identical lasing members 14, 16 shown in Figs. 1 and 2 are two DFB-lasing members (DFB laser member: Distributed Feedback Lasing member). Each of the DFB lasing members (distributed feedback lasing members) is a type of lasing member (especially laser diode), where an active region of the lasing member 14, 16 is periodically structured as a diffraction grating being the wavelength-selective structure. The structure builds a one dimensional interference grating (enabling Bragg scattering), wherein the interference grating provides optical feedback for the respective lasing member 14, 16.

During a process of generating calibration data of the tunable laser device 10 by illuminating the other lasing member 16 with ultraviolet light emitted by the light source, the one lasing member 14 is covered by a shielding member for protecting the one lasing member 14 with respect to the ultraviolet light (Fig. 1).

In a further region of the chip a data storage structure 36 is established. The data storage structure 36 is a ROM-structure (ROM: Read Only Memory), especially an EEPROM-structure (Electrically Erasable Programmable Read-Only Memory) for saving a look up table (LUT) of the measured spectrum of the laser device 10. Alternatively, the data storage device 36 is a device separated from the substrate 12.

The tunable laser device preferably is a laser module of a transceiver device. The transceiver device further comprises a diode module (APC-diode or PIN-diode module), and a controlling device usable for controlling the light source, wherein the controlling device preferably is a micro-controller (µC) or a field-programmable gate array (FPGA).

Each tunable laser device 10 shown in Figs. 1 and 2 is a DFB laser device with a lasing member 14 and an additional calibration lasing member (the other lasing member 16) of a so called "optical network unit" for a fibre optic cable network, especially passive optical network system (PON-system).

While the invention has been illustrated and described in detail in the drawings and foregoing description, such illustration and description are to be considered illustrative or exemplary and not restrictive; the invention is not limited to the disclosed embodiments.

Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### List of Reference Numerals:

- 10: laser device
- 12: substrate
- 14: lasing member
- 16: other lasing member
- 18: arrangement
- 20: first optical element
- 22: optical path
- 24: second optical element
- 26: optical path
- 28: common optical path
- 30: housing
- 32: opening
- 34: light guide member
- 36: data storage structure

## Claims

1. Method for manufacturing and calibrating a tunable laser device (10), comprising a first lasing member (14) with a first wavelength-selective structure, a second lasing member (16) with a second wavelength-selective structure, and a light source for illuminating said lasing members (14,16), comprising the steps:
manufacturing an arrangement (18) of the first lasing member (14) and the second lasing member (16) on a common substrate (12) by means of a common lithographic manufacturing process, wherein the second lasing member (16) is identical to the first lasing member (14), wherein the lasing members (14, 16) of the arrangement (18) are illuminatable by the light source with the same intensity of light, wherein the chemical and/or mechanical structure of the lasing member (14,16) may be changed because of the photo energy of the light emitted by the light source, wherein the light source is a UV-light source for emitting ultraviolet light, wherein the UV-light source is a UV-LED, and wherein the first lasing member (14), the second lasing member (16) and the light source are encapsulated by a housing (30); and
- generating calibration data of the tunable laser device (10) by illuminating the second lasing member (16) with light emitted by the light source, wherein the calibration data are based on a wavelength versus light source power characteristic, and tuning the corresponding laser beam by the use of the second wavelength-selective structure of said second lasing member (16);
- storing said calibration data for adjusting the tunable laser device (10) using the first lasing member (14).

2. Method according to claim 1, wherein the first lasing member (14) and the second lasing member (16) are identical DFB-lasing members of the laser device (10).

3. Method according to one of claims 1 to 2, wherein at least one lithographic tool for defining an identical lateral structure of the first lasing member (14) and the second lasing member (16) is used in the common manufacturing process.

4. Method according to claim 3, wherein the lithographic tool is a lithographic mask for defining the lateral structures of the first lasing member (14) and the second lasing member (16).

5. Method according to one of claims I to 4, wherein the light source is manufactured on the common substrate (12) as well.

6. Method according to one of claims I to 5, wherein the common substrate (12) is at least part of a semiconductor die or a chip.

7. Method according to claim 6, further comprising the step of manufacturing a data storage structure (36) on the chip for saving the calibrating data of the tunable laser device (10).

8. Method according to one of claims 1 to 7, wherein the first lasing member (14) is covered by an optical opaque cover member during the step of generating the calibration data, wherein the optical opaque member is removed after executing this step.

9. Tunable laser device (10) comprising a first lasing member (14) with a first wavelength-selective structure, a second lasing member (16) with a second wavelength-selective structure and a light source for illuminating said lasing members (14, 16),
an arrangement (18) of the first lasing member (14) and the second lasing member (16) being manufactured on a common substrate (12) by means of a common lithographic manufacturing process,
wherein the first wavelength-selective structure of the frst lasing member (14) is identical to the second wavelength-selective structure of the second lasing member (16),
wherein the lasing members (14, 16) of the arrangement (18) are illuminatable by the light source with the same intensity of light, wherein the chemical and/or mechanical structure of the lasing member (14, 16) may be changed because of the photo energy of the light emitted by the light source,
wherein the light source is a UV-light source for emitting ultraviolet light, wherein the UV-light source is a UV-LED,
wherein the first lasing member (14), the second lasing member (16) and the light source are encapsulated by a housing (30), and
wherein the laser device (10) further comprises a data storage structure (36) on the common substrate (12) for saving calibrating data of the tunable laser device (10).

10. Laser device according to claim 9, wherein the first lasing member (14) and the second lasing member (16) are identical DFB-Iasing members of the laser device (10).

11. Laser device according to claim 9 or 10, wherein the light source is arranged on the common substrate (12) as well.

## Patentansprüche

1. Verfahren zum Herstellen und Kalibrieren einer abstimmbaren Laservorrichtung (10), umfassend ein erstes Laserelement (14) mit einer ersten wellenlängenselektiven Struktur, ein zweites Laserelement (16) mit einer zweiten wellenlängenselektiven Struktur und eine Lichtquelle zum Beleuchten besagter Laserelemente (14, 16), die folgenden Schritte umfassend:
- Herstellen einer Anordnung (18) des ersten Laserelements (14) und des zweiten Laserelements (16) auf einem gemeinsamen Substrat (12) mittels eines gemeinsamen lithographischen Herstellungsprozesses, wobei das zweite Laserelement (16) identisch ist mit dem ersten Laserelement (14), wobei die Laserelemente (14, 16) der Anordnung (18) mittels der Lichtquelle mit derselben Lichtintensität beleuchtet werden, wobei die chemische und/oder mechanische Struktur der Laserelemente (14, 16) geändert werden kann aufgrund der Fotoenergie des Lichts, das von der Lichtquelle emittiert wird, wobei die Lichtquelle eine UV-Lichtquelle ist zum Emittieren von ultraviolettem Licht, wobei die UV-Lichtquelle eine UV-LED ist und wobei das erste Laserelement (14), das zweite Laserelement (16) und die Lichtquelle verkapselt sind durch ein Gehäuse (30); und
- Erzeugen von Kalibrierungsdaten der abstimmbaren Laservorrichtung (10) durch Beleuchten des zweiten Laserelements (16) mit Licht, das von der Lichtquelle emittiert wird, wobei die Kalibrierungsdaten auf einer Eigenschaft von Wellenlänge gegen Lichtquellenleistung basieren, und Abstimmen des entsprechenden Laserstrahls mittels des Gebrauchs der zweiten wellenlängenselektiven Struktur von besagtem zweiten Laserelement (16);
- Speichern besagter Kalibrierungsdaten zum Einstellen der abstimmbaren Laservorrichtung (10) unter Benutzen des ersten Laserelements (14).

2. Verfahren nach Anspruch 1, wobei das erste Laserelement (14) und das zweite Laserelement (16) identische DFB-Laserelemente der Laservorrichtung (10) sind.

3. Verfahren nach einem der Ansprüche 1 bis 2, wobei mindestens ein Lithographie-Werkzeug zum Definieren der identischen lateralen Struktur des ersten Laserelements (14) und des zweiten Laserelements (16) in dem gemeinsamen Herstellungsprozess verwendet wird.

4. Verfahren nach Anspruch 3, wobei das Lithographie-Werkzeug eine Lithographiemaske ist zum Definieren der lateralen Strukturen des ersten Laserelements (14) und des zweiten Laserelements (16).

5. Verfahren nach einem der Ansprüche 1 bis 4, wobei die Lichtquelle auch auf dem gemeinsamen Substrat (12) hergestellt wird.

6. Verfahren nach einem der Ansprüche 1 bis 5, wobei das gemeinsame Substrat (12) mindestens Teil eines Halbleiter-Würfels oder Chips ist.

7. Verfahren nach Anspruch 6, weiterhin umfassend den Schritt der Herstellung einer Datenspeicherstruktur (36) auf dem Chip zum Speichern der Kalibrierungsdaten der abstimmbaren Laservorrichtung (10).

8. Verfahren nach einem der Ansprüche 1 bis 7, wobei das erste Laserelement (14) mit einem optisch opaken Abdeckelement bedeckt ist während des Schrittes des Erzeugens der Kalibrierungsdaten, wobei das optisch opake Element nach der Ausführung dieses Schrittes entfernt wird.

9. Abstimmbare Laservorrichtung (10), umfassend ein erstes Laserelement (14) mit einer ersten wellenlängenselektiven Struktur, ein zweites Laserelement (16) mit einer zweiten wellenlängenselektiven Struktur und eine Lichtquelle zum Beleuchten besagter Laserelemente (14, 16),
eine Anordnung (18) des ersten Laserelements (14) und des zweiten Laserelements (16), die auf einem gemeinsamen Substrat (12) mittels eines gemeinsamen lithographischen Herstellungsprozesses hergestellt wird,
wobei die erste wellenlängenselektive Struktur des ersten Laserelements (14) identisch ist mit der der zweiten wellenlängenselektiven Struktur des zweiten Laserelements (16),
wobei die Laserelemente (14, 16) der Anordnung (18) beleuchtbar sind mittels der Lichtquelle mit derselben Lichtintensität, wobei die chemische und/oder mechanische Struktur der Laserelemente (14, 16) geändert werden kann aufgrund der Fotoenergie des Lichts, das von der Lichtquelle emittiert wird,
wobei die Lichtquelle eine UV-Lichtquelle ist
zum Emittieren von ultraviolettem Licht, wobei die UV-Lichtquelle eine UV-LED ist,
wobei das erste Laserelement (14), das zweite Laserelement (16) und die Lichtquelle verkapselt sind durch ein Gehäuse (30),
und wobei die Laservorrichtung (10) weiterhin umfasst eine Datenspeicherstruktur (36) auf dem gemeinsamen Substrat (12) zum Speichern von Kalibrierungsdaten der abstimmbaren Laservorrichtung (10).

10. Laservorrichtung nach Anspruch 9, wobei das erste Laserelement (14) und das zweite Laserelement (16) identische DFB-Laserelemente der Laservorrichtung (10) sind.

11. Laservorrichtung nach Anspruch 9 oder 10, wobei die Lichtquelle auch auf dem gemeinsamen Substrat (12) angeordnet ist.

## Revendications

1. Procédé de fabrication et d'étalonnage d'un dispositif laser accordable (10), comprenant un premier élément d'émission laser (14) avec une première structure à sélection de longueurs d'onde, un deuxième élément d'émission laser (16) avec une deuxième structure à sélection de longueurs d'onde, et une source lumineuse pour éclairer lesdits éléments d'émission laser (14, 16), comprenant les étapes suivantes :
- fabriquer un agencement (18) du premier élément d'émission laser (14) et du deuxième élément d'émission laser (16) sur un substrat commun (12) au moyen d'un processus de fabrication lithographique commun, dans lequel l'élément d'émission laser (16) est identique au premier élément d'émission laser (14), dans lequel les éléments d'émission laser (14, 16) de l'agencement (18) peuvent être éclairés par la source lumineuse avec la même intensité lumineuse, dans lequel la structure chimique et/ou mécanique de l'élément d'émission laser (14, 16) peut être modifiée en raison de la photo énergie de la lumière émise par la source lumineuse, dans lequel la source lumineuse est une source de lumière UV pour émettre une lumière ultraviolette, dans lequel la source est une DEL UV, et dans lequel le premier élément d'émission laser (14), le deuxième élément d'émission laser (16) et la source lumineuse sont encapsulés par un boîtier (30) ; et
- générer des données d'étalonnage du dispositif laser accordable (10) en éclairant le deuxième élément d'émission laser (16) avec la lumière émise par la source lumineuse, dans lequel les données d'étalonnage sont basées sur une caractéristique de longueur d'onde par rapport à la puissance de la source lumineuse, et accorder le faisceau laser correspondant en utilisant la deuxième structure à sélection de longueurs d'ondes dudit deuxième élément d'émission laser (16) ;
- stocker lesdites données d'étalonnage pour régler le dispositif laser accordable (10) en utilisant le premier élément d'émission laser (14).

2. Procédé selon la revendication 1, dans lequel le premier élément d'émission laser (14) et le deuxième élément d'émission laser (16) sont des éléments d'émission laser à rétroaction répartie identiques du dispositif laser (10).

3. Procédé selon l'une des revendications 1 à 2, dans lequel au moins un outil lithographique pour définir une structure latérale identique du premier élément d'émission laser (14) et du deuxième élément d'émission laser (16) est utilisé dans le processus de fabrication commun.

4. Procédé selon la revendication 3, dans lequel l'outil lithographique est un masque lithographique pour définir les structures latérales du premier élément d'émission laser (14) et du deuxième élément d'émission laser (16).

5. Procédé selon l'une des revendications 1 à 4, dans lequel la source lumineuse est également fabriquée sur le substrat commun (12).

6. Procédé selon l'une des revendications 1 à 5, dans lequel le substrat commun (12) fait au moins partie d'une puce de semi-conducteur ou d'une puce.

7. Procédé selon la revendication 6, comprenant en outre l'étape de fabrication d'une structure de stockage de données (36) sur la puce pour sauvegarder les données d'étalonnage du dispositif laser accordable (10).

8. Procédé selon l'une des revendications 1 à 7, dans lequel le premier élément d'émission laser (14) est recouvert d'un élément de couverture optique opaque durant l'étape de génération des données d'étalonnage, dans lequel l'élément optique opaque est retiré après l'exécution de cette étape.

9. Dispositif laser accordable (10) comprenant un premier élément d'émission laser (14) avec une première structure à sélection de longueurs d'onde, un deuxième élément d'émission laser (16) avec une deuxième structure à sélection de longueurs d'onde et une source lumineuse pour éclairer lesdits éléments d'émission laser (14, 16),
un agencement (18) du premier élément d'émission laser (14) et du deuxième élément d'émission laser (16) fabriqué sur un substrat commun (12) au moyen d'un processus de fabrication lithographique commun,
dans lequel la première structure à sélection de longueurs d'onde du premier élément d'émission laser (14) est identique à la deuxième structure à sélection de longueurs d'onde du deuxième élément d'émission laser (16),
dans lequel les éléments d'émission laser (14, 16) de l'agencement (18) peuvent être éclairés par la source lumineuse avec la même intensité lumineuse, dans lequel la structure chimique et/ou mécanique de l'élément d'émission laser (14, 16) peut être modifiée en raison de la photo énergie de la lumière émise par la source lumineuse,
dans lequel la source lumineuse est une source de lumière UV pour émettre une lumière ultraviolette, dans lequel la source de lumière UV est une DEL UV,
dans lequel le premier élément d'émission laser (14), le deuxième élément d'émission laser (16) et la source lumineuse sont encapsulés par un boîtier (30), et
dans lequel le dispositif laser (10) comprend en outre une structure de stockage de données (36) sur le substrat commun (12) pour sauvegarder des données d'étalonnage du dispositif laser accordable (10).

10. Dispositif laser selon la revendication 9, dans lequel le premier élément d'émission laser (14) et le deuxième élément d'émission laser (16) sont des éléments d'émission laser à rétroaction répartie identiques du dispositif laser (10).

11. Dispositif laser selon la revendication 9 ou 10, dans lequel la source lumineuse est également disposée sur le substrat commun (12).
